# EUROPEAN PATENT SPECIFICATION

(11) **EP 1 523 806 B1**
(45) Date of publication and mention of the grant of the patent: **12.12.2007**
(21) Application number: 03764724.5
(22) Date of filing: 16.07.2003
(51) Int. Cl.: H03K 3/03

(54) **RING OSCILLATOR WITH FREQUENCY STABILIZATION**
RINGOSZILLATOR MIT FREQUENZSTABILISIERUNG
OSCILLATEUR EN ANNEAU AVEC STABILISATION DE FREQUENCE

(30) Priority: 16.07.2002 US 195949
(43) Date of publication of application: 20.04.2005
(73) Proprietor: NXP B.V., 5656 AG Eindhoven (NL)
(72) Inventor: ILLEGEMS, Paul F., San Jose, CA 95131 (US)
(74) Representative: Pennings, Johannes
(86) International application number: PCT/US2003/022188
(87) International publication number: WO 2004/008639

(56) References cited:
- EP-A- 1 324 491
- WO-A-02/13384
- US-A- 5 072 197
- US-A- 5 440 277
- US-A- 5 905 412
- US-B1- 6 404 295

## Description

### BACKGROUND OF THE INVENTION

### 1. Field of the Invention

This invention relates to the field of electronic circuits, and in particular to a ring oscillator that provides a stable frequency over a variety of process, voltage, and temperature conditions.

### 2. Description of Related Art

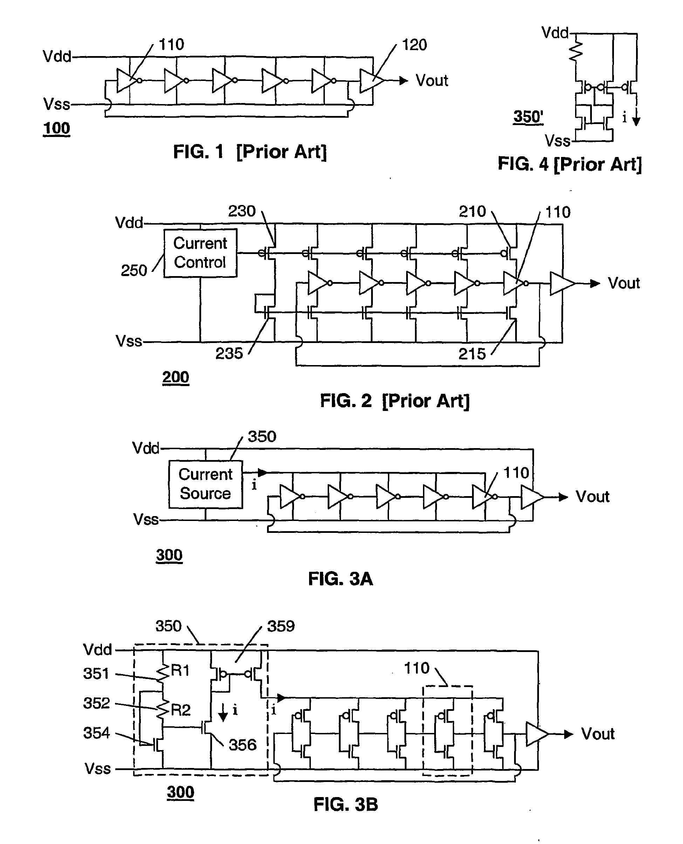

Ring oscillators are common in the art, and comprise an odd number of inverters connected in a series-ring configuration. FIG. 1 illustrates an example ring oscillator 100 that has five inverters 110 connected in a ring. A buffer 120 provides the output of the oscillator 100 to a load (not shown) and isolates the ring oscillator 100 from the load. Because there are an odd number of inverters 110 in the ring, each inverter continually switches state. The frequency of oscillation of the oscillator 100 is determined by the speed at which the inverters 110 change state, which is primarily determined by the size of the devices used in the inverters 110. The switching speed is also dependent upon the parameters of the process used for creating the oscillator 100, the operating temperature, and the supply voltage (Vdd-Vss). In a typical span of process parameters (slow, medium, fast), temperature (0-120°C), and supply voltage (1.6-2.0V), the frequency of oscillation may vary by as much as 40% from nominal.

US patent 5,331,295, "VOLTAGE CONTROLLED OSCILLATOR WITH EFFICIENT PROCESS COMPENSATION", issued 19 July 1994 to Jelinek et al., teaches a current-controlled ring-oscillator that provides a controlled oscillation frequency that includes compensation for process, voltage, and temperature variations. FIG. 2 illustrates an example ring oscillator 200 as taught by Jelinek et al. The current to each inverter stage 110 is controlled by current-limiting transistors 210, 215. A current controller 250 controls each of the current-limiting transistors 210. A transistor pair 230, 235 is configured to provide an equal current to the corresponding current-limiting transistors 215.

US-A-5072197 depicts a compensation circuit for a ring oscillator having an odd plurality of series-connected CMOS inverter stages. The oscillator includes first and second P-channel transistors and a resistor. The first transistor has a source coupled to VDD and a gate coupled to ground. The resistor is coupled between the drain of the first transistor and ground. The second transistor has a source coupled to VDD, a gate coupled to the drain of the first transistor, and a drain coupled to a supply node of each of the inverter stages of the ring oscillator for providing a supply voltage that is compensated with respect to voltage, temperature, and semiconductor processing variables. In operation, the conductivity of the first transistor inversely controls the conductivity of the second transistor that supplies a compensated power to the inverter stages. The compensated power controls the conductivity of the transistors in the ring oscillator and the corresponding frequency of oscillation.

WO 02/13384 describes a timer circuit exhibiting a timer period, which decreases with a rise of temperature and increases with a fall of temperature. A diode has a current characteristic depending on temperature. The forward current flows through an n-type MOS transistor constituting the primary side of a current mirror. Depending on the current flowing through the n-type MOS transistor, the current flowing through a p-type MOS transistor and an n-type MOS transistor constituting the secondary side of the current mirror is determined. The current flowing through the p-type MOS transistor and the n-type MOS transistor is supplied as the operating current of a ring oscillator constituted of inverters. Therefore, the period (timer period) of a clock signal CLK outputted from the ring oscillator reflects the temperature characteristics of the diode, and the timer period decreases with a rise of temperature.

### BRIEF SUMMARY OF THE INVENTION

It is an object of this invention to provide a simple yet effective means for providing an oscillation frequency that is stable across a variety of process, voltage, and temperature variations. It is a further object of this invention to provide a ring oscillator that is stable across a variety of process, voltage, and temperature variations, that use very few components to achieve this stability.

The invention is defined by the independent claim. Dependent claims describe advantageous embodiments.

### BRIEF DESCRIPTION OF THE DRAWINGS

The invention is explained in further detail, and by way of example, with reference to the accompanying drawings wherein:
Fig. 1 illustrates an example block diagram of a prior art ring oscillator.
Fig. 2 illustrates an example block diagram of a prior art ring oscillator with process, voltage, and temperature compensation.
Figs. 3A and 3B illustrate an example block diagram and an example circuit diagram, respectively, of a ring oscillator with process, voltage, and temperature compensation in accordance with this invention.
Fig. 4 illustrates an example circuit diagram of a prior art temperature compensating current source.

Throughout the drawings, the same reference numerals indicate similar or corresponding features or functions.

### DETAILED DESCRIPTION OF THE INVENTION

FIGs. 3A and 3B illustrate an example block diagram and an example circuit diagram, respectively, of a ring oscillator 300 with process, voltage, and temperature compensation in accordance with this invention. A current source 350 provides a substantially constant current that is used to supply the operating current to each of the inverter stages 110 of the ring oscillator 300. This substantially constant current is controlled so as to compensate for voltage, temperature, and process variations, as detailed further below. That is, the controlled current is substantially constant at a current value that is dynamically varied, depending upon the particular set of voltage, temperature, and process conditions.

The switching of each inversion stage 110 comprises a repeated charging and discharging of capacitances within each inversion stage. The prior art ring oscillator 200 of FIG. 2 provides frequency-regulation by controlling the current provided to each inversion stage, thereby controlling the time required to charge and discharge the capacitances of each inversion stage.

The invention of this application is premised on the observation that the inherent symmetry of a ring oscillator produces a relatively constant total current draw, or at least a symmetric and repetitive current draw from period to period. By providing a controlled-current supply to all of the inversion stages 110, the current consumption per period is approximately constant, and therefore the oscillation frequency is constant. Recognizing this inherent symmetry, the need for independent current-control for each stage, as in the prior ring oscillator 200 of FIG. 2, is avoided, thereby providing a less costly and less complex embodiment, as compared to the oscillator 200.

The current source 350 is configured to provide the controlled current over a wide range of process, voltage, and temperature variations, such that the frequency of oscillation of the ring counter is controlled to within a limited variance. As the operating temperature of the ring oscillator increases, the speed of switching decreases, thereby reducing the frequency of oscillation. In a straightforward embodiment, a conventional PTAT (proportional to absolute temperature) current source may be used to provide a current that increases with temperature, to compensate for this frequency reduction. The degree of compensation required can be determined using conventional circuit simulation tools, and/or circuit optimization tools.

In like manner, regarding process parameters, the switching speed varies inversely with the threshold voltage of the transistors in the ring oscillator, and directly with the gain, or beta, of the transistors. Therefore in a preferred embodiment, the current source 350 is also configured to increase the supplied current when the transistor threshold voltage increases, and when the transistor beta decreases.

Also preferably, the current source 350 is configured to provide the aforementioned temperature-compensated and/or process-compensated controlled current substantially independent of the supply voltage. As is common in the art, for example, a bandgap voltage reference, which may be implemented using bipolar or field-effect circuits, typically includes a PTAT current flow in one or more of its branches.

In a preferred embodiment, as illustrated in FIG. 3B, the current source 350 comprises a pair of series connected resistors R1 351, R2 352 that control the current through a series connected transistor 354. The common node between the series connected resistors 351, 352 provides the control voltage at the gate of transistor 354, and the terminal node of the series provides the current through the transistor 354. The terminal node of the series also provides the control voltage at the gate of a transistor 356 that provides the controlled current, i, via a current mirror arrangement 359. The particular values of R1, R2, and the sizes of the transistors 354 and 356 are determined using conventional circuit simulation and optimization techniques so as to provide a relatively constant oscillation frequency over a given set of process, temperature, and voltage conditions. In an example embodiment, the following values provided for less than 10% variation in oscillator frequency over a typical span of process parameters (slow, nominal, fast), temperature (0-120°C), and supply voltage (1.6-2.0V):
R1=116.7 KΩ;
R2=10.4 KΩ;
T 354: width 4 µm, length 1.06 µm; and
T 356: width 8.42 µm, length 3.2 µm.
This result compares very favorably to the aforementioned typical 40% variation of the conventional ring oscillator 100 of FIG. 1. Similar results were found using a conventional PTAT current source, such as illustrated as 350' in FIG. 4.

Although the example circuits of FIG. 3B and FIG. 4 illustrate the use of field-effect transistors, one of ordinary skill in the art will recognize that other technologies, such as bipolar, may also be used to provide the controlled current, i. As noted above, the controlled current, i, preferably:
- increases with temperature;
- increases with transistor threshold voltage;
- decreases with transistor beta; and
- remains constant with supply voltage.

The foregoing merely illustrates the principles of the invention. It will thus be appreciated that those skilled in the art will be able to devise various arrangements, which, although not explicitly described or shown herein, embody the principles of the invention and are thus within the scope of the following claims.

## Claims

1. A ring oscillator, comprising:
- a current generator (350) for providing a controlled output current (i),
- an odd number of inversion stages (110) coupled in a ring configuration, and further coupled to the current generator (350), the inversion stages (110) being commonly powered by the controlled output current (i),
- the current generator (350) including:
- a first resistor (351) coupled between a first voltage source terminal and a first node,
- a first transistor (354) having a control terminal that controls current flow between a first terminal and a second terminal of the first transistor, the control terminal being coupled to the first node, the first terminal being coupled to a second node, different from said first node and the second terminal being coupled to a second voltage source terminal; and
- a current mirror arrangement (359, 356) for providing the controlled output current (i), and having a control terminal coupled to the second node, the current generator being **characterized in that** it further comprises
- a second resistor (352) coupled between the first node and the second node.,

2. The ring oscillator of claim 1, wherein each of the inversion stages include a third transistor having a gate that controls current flow between a first terminal and a second terminal of the third transistor, the gate being coupled to a prior inversion stage, the first terminal being coupled to the controlled current output, and the second terminal being coupled to a next inversion stage; and a fourth transistor having a gate that controls current flow between a first terminal and a second terminal of the fourth transistor, the gate being coupled to the prior inversion stage, the first terminal being coupled to the next inversion stage, and the second terminal being coupled to the second voltage source.

3. The ring oscillator of claim 1, wherein the current mirror arrangement comprises a second transistor having a control terminal coupled to the second node, and wherein resistance values of the first resistor and the second resistor, and size values of the first transistor and a second transistor are determined so as to provide the controlled current output to produce a substantially constant oscillation frequency over a wide range of process, voltage, and temperature variations.

4. The ring oscillator of claim 1, wherein the current generator is configured to increase the controlled current output based on at least one of:
- an increase in operating temperature,
- an increase in threshold voltage, and
- a decrease in beta.

5. The ring oscillator of claim 1, wherein the current generator is configured to provide the controlled current output independent of a variance of a supply voltage to the current generator.

6. The ring oscillator of claim 1, wherein each of the inversion stages include:
- a first inversion stage transistor having a gate that controls current flow between a first terminal and a second terminal of the first inversion stage transistor, the gate being coupled to a prior inversion stage, the first terminal being coupled to the controlled current output, and the second terminal being coupled to a next inversion stage; and
- a second inversion stage transistor having a gate that controls current flow between a first terminal and a second terminal of the second inversion stage transistor, the gate is coupled to the prior inversion stage, the first terminal being coupled to the next inversion stage, the second terminal being coupled to the second voltage source.

7. The ring oscillator of claim 1, wherein the current generator includes a proportional to absolute temperature current generator.

## Patentansprüche

1. Ein Ringoszillator, umfassend:
- einen Stromgenerator (350) zur Bereitstellung eines geregelten Ausgangsstroms (i),
- eine ungerade Anzahl von Inversionsstufen (110), die in einer Ringkonfiguration gekoppelt und ferner an den Stromgenerator (350) gekoppelt sind, wobei die Inversionsstufen (110) gemeinsam durch den geregelten Ausgangsstrom (i) mit Strom versorgt werden,
- wobei der Stromgenerator (350) einschließt:
- einen ersten Widerstand (351), der zwischen einem ersten Spannungsquellenanschluss und einem ersten Knoten gekoppelt ist,
- einen ersten Transistor (354), der einen Steueranschluss hat, der den Stromfluss zwischen einem ersten Anschluss und einem zweiten Anschluss des ersten Transistors steuert, wobei der Steueranschluss an den ersten Knoten gekoppelt ist, der erste Anschluss an einen zweiten Knoten gekoppelt ist, der sich von besagtem ersten Knoten unterscheidet, und der zweite Anschluss an einen zweiten Spannungsquellenanschluss gekoppelt ist, und
- eine Stromspiegelanordnung (359, 356) zur Bereitstellung des geregelten Ausgangsstroms (i) mit einem Steueranschluss, der an den zweiten Knoten gekoppelt ist, wobei der Stromgenerator **dadurch gekennzeichnet ist, dass** er ferner umfasst
- einen zweiten Widerstand (352), der zwischen dem ersten Knoten und dem zweiten Knoten gekoppelt ist.

2. Der Ringoszillator nach Anspruch 1, wobei jede der Inversionsstufen einschließt: einen dritten Transistor, der ein Gate hat, das den Stromfluss zwischen einem ersten Anschluss und einem zweiten Anschluss des dritten Transistors steuert, wobei das Gate an eine vorhergehende Inversionsstufe gekoppelt ist, der erste Anschluss an den geregelten Ausgangsstrom gekoppelt ist und der zweite Anschluss an eine nächste Inversionsstufe gekoppelt ist; und einen vierten Transistor, der ein Gate hat, das den Stromfluss zwischen einem ersten Anschluss und einem zweiten Anschluss des vierten Transistors steuert, wobei das Gate an die vorhergehende Inversionsstufe gekoppelt ist, der erste Anschluss an die nächste Inversionsstufe gekoppelt ist und der zweite Anschluss an die zweite Spannungsquelle gekoppelt ist.

3. Der Ringoszillator nach Anspruch 1, wobei die Stromspiegelanordnung einen zweiten Transistor umfasst, der einen Steueranschluss hat, der an den zweiten Knoten gekoppelt ist, und wobei Widerstandswerte des ersten Widerstands und des zweiten Widerstands und Größenwerte des ersten Transistors und eines zweiten Transistors so bestimmt werden, dass der geregelte Ausgangsstrom zur Erzeugung einer im Wesentlichen konstanten Schwingungsfrequenz über einen weiten Bereich von Prozess-, Spannungs- und Temperaturschwankungen hinweg bereitgestellt wird.

4. Der Ringoszillator nach Anspruch 1, wobei der Stromgenerator so konfiguriert ist, dass er den geregelten Ausgangsstrom auf mindestens einer der folgenden Grundlagen erhöht:
- ein Anstieg der Betriebstemperatur,
- ein Anstieg der Schwellenspannung, und
- ein Absinken des Beta-Werts.

5. Der Ringoszillator nach Anspruch 1, wobei der Stromgenerator so konfiguriert ist, dass er den geregelten Ausgangsstrom unabhängig von einer Abweichung einer dem Stromgenerator zugeführten Speisespannung bereitstellt.

6. Der Ringoszillator nach Anspruch 1, wobei jede der Inversionsstufen einschließt:
- einen ersten Inversionsstufentransistor, der ein Gate hat, das den Stromfluss zwischen einem ersten Anschluss und einem zweiten Anschluss des ersten Inversionsstufentransistors steuert, wobei das Gate an eine vorhergehende Inversionsstufe gekoppelt ist, der erste Anschluss an den geregelten Ausgangsstrom gekoppelt ist und der zweite Anschluss an eine nächste Inversionsstufe gekoppelt ist; und
- einen zweiten Inversionsstufentransistor, der ein Gate hat, das den Stromfluss zwischen einem ersten Anschluss und einem zweiten Anschluss des zweiten Inversionsstufentransistors steuert, wobei das Gate an die vorhergehende Inversionsstufe gekoppelt ist, der erste Anschluss an die nächste Inversionsstufe gekoppelt ist und der zweite Anschluss an die zweite Spannungsquelle gekoppelt ist.

7. Der Ringoszillator nach Anspruch 1, wobei der Stromgenerator einen Proportional-zur-absoluten-Temperatur-Stromgenerator einschließt.

## Revendications

1. Oscillateur à anneau comprenant :
- un générateur de courant (350) pour fournir un courant de sortie commandé (i),
- un nombre impair d'étages d'inversion (110) couplés dans une configuration d'anneau et en outre couplés au générateur de courant (350), les étages d'inversion (110) étant communément alimentés par le courant de sortie commandé (i),
- le générateur de courant (350) comprenant :
- une première résistance (351) couplée entre une première borne de source de tension et un premier noeud,
- un premier transistor (354) comportant une borne de commande qui commande le flux de courant entre une première borne et une seconde borne du premier transistor, la borne de commande étant couplée au premier noeud, la première borne étant couplée à un second noeud différent dudit premier noeud et la seconde borne étant couplée à une seconde borne de source de tension ; et
- un agencement de miroir de courant (359, 356) pour fournir le courant sorti commandé (i), et comportant une borne de commande couplée au second noeud, le générateur de courant étant **caractérisé en ce qu'**il comprend en outre
- une seconde résistance (352) couplée entre le premier noeud et le second noeud.

2. Oscillateur à anneau selon la revendication 1, dans lequel chacun des étages d'inversion comprend un troisième transistor comportant une grille qui commande un flux de courant entre une première borne et une seconde borne du troisième transistor, la grille étant couplée à un étage d'inversion précédent, la première borne étant couplée à la sortie de courant commandé et la seconde borne étant couplée à un étage d'inversion suivant ; et un quatrième transistor comportant une grille qui commande un flux de courant entre une première borne et une seconde borne du quatrième transistor, la grille étant couplée à l'étage d'inversion précédent, la première borne étant couplée à l'étage d'inversion suivant et la seconde borne étant couplée à la seconde source de tension.

3. Oscillateur à anneau selon la revendication 1, dans lequel l'agencement de miroir de courant comprend un deuxième transistor comportant une borne de commande couplée au second noeud et dans lequel les valeurs de résistance de la première résistance et de la seconde résistance ainsi que les valeurs de taille du premier transistor et du deuxième transistor sont déterminées de manière à fournir la sortie de courant commandé pour produire une fréquence d'oscillation sensiblement constante sur une large gamme de variations de procédé, de tension et de température.

4. Oscillateur à anneau selon la revendication 1, dans lequel le générateur de courant est configuré pour accroître la sortie de courant commandé sur la base d'au moins un des éléments suivants :
- une augmentation de la température de fonctionnement,
- une augmentation de la tension de seuil, et
- une diminution de bêta.

5. Oscillateur à anneau selon la revendication 1, dans lequel le générateur de courant est configuré pour fournir la sortie de courant commandé indépendamment d'une variation d'une tension d'alimentation au générateur de courant.

6. Oscillateur à anneau selon la revendication 1, dans lequel chacun des étages d'inversion comprend :
- un premier transistor d'étage d'inversion comportant une grille qui commande un flux de courant entre une première borne et une seconde borne du premier transistor d'étage d'inversion, la grille étant couplée à un étage d'inversion précédent, la première borne étant couplée à la sortie de courant commandé et la seconde borne étant couplée à un étage d'inversion suivant ; et
- un second transistor d'étage d'inversion comportant une grille qui commande un flux de courant entre une première borne et une seconde borne du second transistor d'étage d'inversion, la grille étant couplée à l'étage d'inversion précédent, la première borne étant couplée à l'étage d'inversion suivant, la seconde borne étant couplée à la seconde source de tension.

7. Oscillateur à anneau selon la revendication 1, dans lequel le générateur de courant comprend un générateur de courant proportionnel à la température absolue.
